Europäisches Patentamt

European Patent Office

Office européen des brevets

(11) Publication number: **0 452 891 A2**

# EUROPEAN PATENT APPLICATION

(21) Application number: 91106074.7

(51) Int. Cl.5: **H01L 21/285**, H01L 21/321

(22) Date of filing: **16.04.91**

(30) Priority: 16.04.90 US 510307
16.04.90 US 509928
16.04.90 US 510340

(43) Date of publication of application:
**23.10.91 Bulletin 91/43**

(84) Designated Contracting States:
**BE DE ES FR GB IT NL**

(71) Applicant: **APPLIED MATERIALS, INC.**
**3050 Bowers Avenue**
**Santa Clara California 95054(US)**

(72) Inventor: **Nulman, Jaim**
**4155-G El Camino Way**
**Palo Alto, CA 94306(US)**
Inventor: **Maydan, Dan**
**12000 Murietta Lane**
**Los Altos Hills, CA 94022(US)**

(74) Representative: **Diehl, Hermann Dr. et al**
**Diehl & Glaeser, Hiltl & Partner**
**Flüggenstrasse 13**
**W-8000 München 19(DE)**

(54) **Process for forming titanium silicide on a semiconductor wafer.**

(57) A process is disclosed for forming a conductive layer of titanium silicide on a silicon semiconductor wafer which comprises the steps of forming a titanium layer over the wafer in a vacuum deposition chamber in the substantial absence of oxygen and/or oxygen-bearing gases; transferring the titanium coated wafer to a sealed annealing chamber without substantially exposing the newly formed titanium layer to oxygen and/or oxygen-bearing gases; and annealing the titanium-coated silicon semiconductor wafer in a nitrogen-bearing atmosphere in the sealed annealing chamber, and in the substantial absence of oxygen and/or oxygen-bearing gases, to form a titanium silicide layer as well as titanium nitride on the surface which inhibits migration of underlying silicon to the surface. In a preferred embodiment, the improved process further includes a cleaning step which uses an rf plasma and at least one reactive gas to clean the wafer in a cleaning chamber prior to the deposition step and the cleaned wafer is then transferred to the vacuum deposition chamber from the cleaning chamber without substantially exposing the wafer to oxygen and/or oxygen-bearing gases.

CLEANING A SILICON SEMICONDUCTOR WAFER IN A CLEANING CHAMBER USING ONE OR MORE REACTIVE GASES WITH AN RF PLASMA

MOVING THE CLEANED WAFER TO A VACUUM DEPOSITION CHAMBER WITHOUT EXPOSING THE CLEANED WAFER TO OXYGEN-BEARING GASES

DEPOSITING A LAYER OF TITANIUM ON THE CLEANED SEMICONDUCTOR WAFER

MOVING THE WAFER FROM THE VACUUM DEPOSITION CHAMBER TO AN ANNEALING CHAMBER WITHOUT EXPOSING THE COATED WAFER TO OXYGEN-BEARING GASES

ANNEALING THE COATED WAFER IN A NITROGEN-BEARING ATMOSPHERE TO FORM TITANIUM SILICIDE AND TITANIUM NITRIDE

Figure 6

This invention relates to the processing of a semiconductor wafer to form an integrated circuit structure thereon. More particularly, this invention relates to a process for forming a layer of titanium silicide on a semiconductor wafer.

In the conventional formation of a titanium silicide layer, as a part of an integrated circuit structure on a semiconductor wafer such as a silicon wafer, those surfaces of the wafer on which the titanium silicide layer is to be formed are first cleaned to remove any materials which might interfere with reaction between the subsequently deposited titanium layer and the exposed silicon portions of the wafer. The surfaces are conventionally cleaned in a vacuum chamber using an inert gas such as argon with an rf plasma. This is sometimes preceded by an oxide wet etch.

Following these cleaning steps, a layer of titanium metal is conventionally deposited over the cleaned wafer structure, for example, using a vacuum sputtering deposition (PVD) process, usually to a thickness ranging from about 100 to about 1000 Angstroms. *

The titanium coated wafer is then conventionally removed from the PVD chamber and transported through the ambient atmosphere to separate annealing apparatus where the structure is annealed in a nitrogen atmosphere and in the absence of oxygen (which would react with the titanium). Usually this annealing step comprises a rapid anneal where the structure is rapidly heated to the annealing temperature of from about $650°$ C to about $675°$ C in a few seconds and then maintained at this annealing temperature for from about 20 to about 60 seconds.

The nitrogen atmosphere results in the simultaneous formation of a titanium nitride layer as the titanium reacts with the silicon to form titanium silicide. This titanium nitride acts as a blocking layer to prevent migration of silicon atoms to the surface, from the underlying silicon.

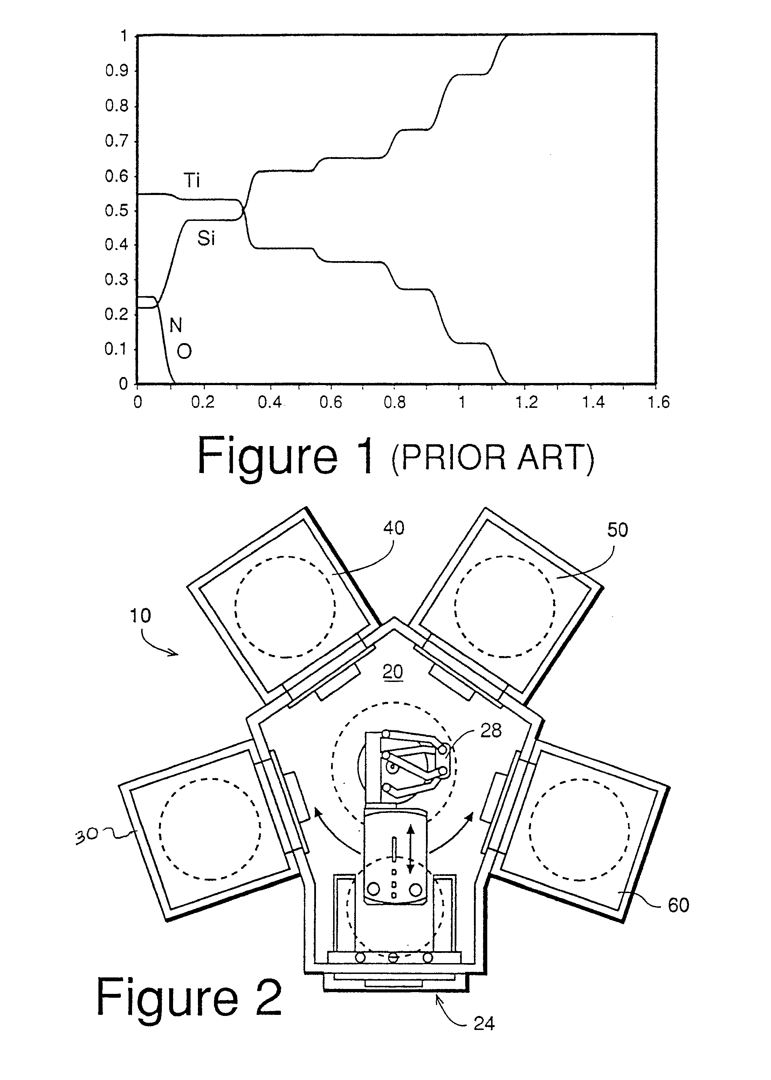

To satisfactorily form the desired titanium nitride blocking layer, it is necessary that the nitrogen atoms penetrate into the titanium layer. Referring to Figure 1, which shows the atomic fraction of titanium, silicon, oxygen, and nitrogen atoms plotted against depth in the surface layer formed during the annealing step in a conventional prior art process, it will be noted that the line labelled "N O" shows the concentration of nitrogen and oxygen in the layer with hardly any nitrogen atoms present below the top 100 Angstroms, and less than 0.25 atomic percent even at the top surface. As a result, silicon atoms are shown in the graph as present on the surface, i.e., to have penetrated through the titanium oxynitride formed adjacent the surface of the coating and to have a concentration, at the top surface, which is almost as high as the nitrogen atom concentration.

This failure of the nitrogen atoms to sufficiently penetrate further into the titanium/titanium silicide layer and failure of the nitrogen atoms to react with the titanium sufficiently to form a titanium nitride layer which blocks migration of silicon atoms is unsatisfactory.

It would, therefore, be desirable to provide a process for the formation of a titanium silicide layer on a semiconductor wafer wherein penetration of nitrogen atoms into the titanium/titanium silicide layer is adequate to result in the formation of a sufficient amount of titanium nitride over both the underlying titanium silicide or silicon oxide to block migration of unreacted silicon atoms to the surface of the layer.

## SUMMARY OF THE INVENTION

It is, therefore, an object of this invention to provide an improved process for the formation of titanium silicide on a semiconductor wafer wherein migration of unreacted silicon atoms to the top surface of the resulting titanium silicide and/or titanium layer is inhibited. This object is solved by the process of independent claims 1 and 3. Further advantageous features and aspects of the invention are evident from the dependent claims, the description and the drawings. The claims are intended to be understood as a first non-limiting approach of defining the invention in general terms.

The invention also provides an integrated processing system for forming titanium silicide on semiconductor wafers.

It is another apsect of this invention to provide an improved process for the formation of titanium silicide on a semiconductor wafer wherein a sufficient amount of titanium nitride is formed to prevent migration of unreacted silicon atoms to the top surface of the resulting layer.

It is yet another aspect of this invention to provide an improved process for the formation of titanium silicide on a semiconductor wafer wherein oxygen is sufficiently excluded from the process to permit a sufficient amount of titanium nitride to be formed to prevent migration of unreacted silicon atoms to the top surface of the resulting layer.

It is still another aspect of this invention to provide an improved process for the formation of titanium silicide on a semiconductor wafer wherein oxygen is excluded from the process by transferring the wafer from a titanium deposition chamber to an annealing chamber without exposing the titanium coated wafer to oxygen or oxygen-bearing

* 1 Angstrom = 0.1 nm

gases which would inhibit penetration of nitrogen atoms into the layer or inhibit formation of titanium nitride therein.

It is a further aspect of this invention to provide an improved process for the formation of titanium silicide on a semiconductor wafer wherein oxygen is excluded from the process by transferring the wafer from a titanium deposition chamber to an annealing chamber under vacuum without exposing the titanium coated wafer to oxygen or oxygen-bearing gases which would inhibit penetration of nitrogen atoms into the layer or inhibit formation of titanium nitride therein.

It is yet a further aspect of this invention to provide an improved process for the formation of titanium silicide on a semiconductor wafer wherein oxygen and/or oxygen-bearing gases such as air are further excluded from the process by cleaning the wafer using a reactive rf ion etch prior to depositing a layer of titanium on the wafer and then transferring the wafer from the titanium deposition chamber to an annealing chamber under vacuum without exposing the titanium coated wafer to oxygen or oxygen-bearing gases which would inhibit penetration of nitrogen atoms into the layer or inhibit formation of titanium nitride therein.

These and other details of the invention will be apparent from the following description and accompanying drawings.

Figure 1 is a graph showing the concentration of silicon, titanium, oxygen, and nitrogen in a titanium silicide layer, as measured by Rutherford Backscattering Profiles (RBS), in a prior art titanium silicide process.

Figure 2 is a top view of an apparatus suitable for carrying out the process of the invention.

Figure 3 is a fragmentary vertical cross-sectional view of a titanium silicide layer formed on a silicon wafer.

Figure 4 is a graph showing the concentration of silicon, titanium, and nitrogen in a titanium silicide layer, as measured by Rutherford Backscattering Profiles (RBS), in the titanium silicide process of the invention.

Figure 5 is a graph showing the sheet resistance of the titanium silicide layer as a function of anneal temperature for various titanium silicides made, respectively, using a prior art technique, as well as the process of the invention.

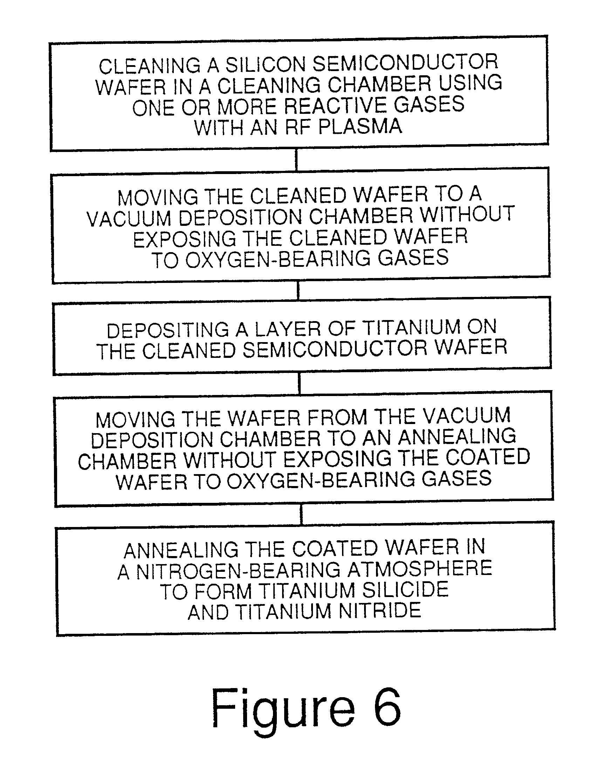

Figure 6 is a flowsheet illustrating the process of the invention.

The process of the invention provides for the formation of a titanium silicide layer on a semiconductor wafer in a nitrogen-bearing atmosphere and in the substantial absence of oxygen-bearing gases such as air to permit formation of a sufficient amount of titanium nitride layer to block the migration of unreacted silicon atoms to the surface.

In one aspect, the process of the invention includes the transfer of the semiconductor wafer, under vacuum and in the substantial absence of oxygen-bearing gases, from a titanium deposition chamber and to an annealing chamber, to inhibit or exclude oxygen in and/or on the newly formed titanium layer on the semiconductor wafer during the annealing portion of the process.

In another aspect the process of the invention further comprises the cleaning of the wafer, prior to the titanium deposition step, using a reactive rf ion etch to more thoroughly remove oxygen and/or oxygen-bearing gases from the wafer surface prior to the titanium deposition step, followed by the transfer of the cleaned wafer, under vacuum and in the substantial absence of oxygen-bearing gases, to the titanium deposition chamber.

By use of the expressions herein "substantial absence of oxygen-bearing gas" and/or "without substantially exposing the newly formed titanium layer to oxygen and/or oxygen-bearing gases" is meant that in the chambers respectively used for the titanium deposition and for annealing, as well as in the vacuum chamber used for the transfer of the wafer therebetween, the atmosphere will contain less than 10 ppm oxygen in any of the chambers.

By use of the term herein "in a nitrogen-bearing atmosphere" is meant an atmosphere containing at least 10 volume % nitrogen. The nitrogen may come from $N_2$ or from any other source which will decompose to provide a source of nitrogen without adding oxygen-bearing gases to the atmosphere, e.g., $NH_3$.

Turning now to Figure 2, an apparatus useful for carrying out the process of the invention is generally indicated at 10 which comprises a sealed central chamber 20 into which a wafer may be loaded through a cassette load lock 24. Central chamber 20 may be maintained at a vacuum ranging from about $10^{-9}$ to about $10^{-5}$ Torr. * In particular, oxygen and other oxygen-bearing gases such as air are excluded from central chamber 20.

Robotic means 28 may be provided within central chamber 20 to transfer the wafer between a cleaning chamber 30, a PVD titanium deposition chamber 40, and an annealing chamber 50 through central chamber 20. An optional degassing chamber 60 may also be provided as a part of apparatus 10, which will also be accessible through central vacuum chamber 20.

Multi-chambered vacuum apparatus for the processing of semiconductor wafers is generally described in Toshima U.S. Patent 4,785,962, cross-

*1 Torr = 1.333 mbar

reference to which is hereby made, and is commercially available, such as, for example, a 5000 Series wafer processing apparatus available from Applied Materials, Inc. in Santa Clara, CA, and such apparatus may be modified for the practice of the present invention.

In the practice of the process of the invention, a single wafer or a group of wafers on a tray is admitted into central chamber 20 of vacuum apparatus 10 through load lock 24 and then a single wafer is transferred to cleaning chamber 30 where the wafer is cleaned to remove any foreign materials from the wafer and, in particular, any oxides from the surface of the exposed silicon.

The wafer may be cleaned using a conventional inert gas RF etch, using argon as the inert gas. However, in accordance with a preferred embodiment of the process of the invention, the wafer is preferably cleaned using a reactive rf ion process such as a $NF_3$/argon mixture by flowing into cleaning chamber 30 from about 2 sccm to about 500 sccm of at least one reactive gas such as $NF_3$ and from about 10 sccm to about 1000 sccm of a carrier gas such as argon while maintaining a vacuum of from about 1 to about 50 milliTorr * in cleaning chamber 30 and an rf plasma at a power level ranging from about 20 to about 500 watts. The cleaning chamber is maintained at a temperature within a range of from about 27°C to about 200°C during the cleaning step which is carried out for a period of from about 1 to about 500 seconds.

Examples of reactive gases which can be used to carry out the reactive ion etch cleaning step of the invention include not only $NF_3$, but also fluorinated 1-2 carbon hydrocarbons such as, for example, $CHF_3$ and $CF_4$, as well as mixtures of same.

After the wafer has been cleaned, it is transferred out of cleaning chamber 30 back to central chamber 20 and then into deposition chamber 40 where a layer of titanium, having a thickness range of from about 100 to about 5000 Angstroms, preferably from about 100 to about 1000 Angstroms, and typically about 500 Angstroms, is conventionally deposited onto the wafer surface using, for example, a PVD sputtering process. It will be noted that in the preferred embodiment of the invention, the cleaned wafer removed from cleaning chamber 30 is not exposed to air or any other oxygen-containing gases, but is rather moved from cleaning chamber 30 through vacuum chamber 20 directly to deposition chamber 40.

After deposition of the titanium layer onto the wafer, the wafer is removed from deposition chamber 40 and, in accordance with the invention, directly transferred to annealing chamber 50 through vacuum chamber 20 without any exposure to oxygen or other oxygen-bearing gases, such as air, which might otherwise adsorb on or enter into the newly deposited titanium layer.

The annealing portion of the process is then carried out in a first annealing step at a temperature ranging from about 600°C up to about 695°C, and preferably at a temperature ranging from about 650°C to about 675°C. This first annealing step is preferably carried out under rapid anneal conditions where the wafer is ramped up to the annealing temperature at a rate of from about 5°C/second to about 150°C/second, typically about 80°C/second, and the first annealing step is then carried out for a period of from about 20 to about 60 seconds.

During this first anneal step, one or more nitrogen-bearing gases are flowed into annealing chamber 50 at a rate ranging from about 500 to about 10,000 sccm (depending upon the pump capacity) while maintaining the pressure in said annealing chamber within a range of from about 100 milliTorr to about 800 Torr.

After this first anneal step, the titanium nitride (TiN), formed over the titanium silicide as well as over silicon oxide ($SiO_2$) portions of the wafer, may be selectively removed using a wet etch such as a mixture of 4 parts by weight $H_2O$, 1 part by weight $H_2O_2$, and 1 part by weight $NH_4OH$ which will remove unreacted titanium and titanium nitride, in preference to titanium silicide and/or silicon oxide.

The wafer may be then again annealed in a second rapid anneal step similar to the first anneal step, but at a temperature ranging from about 800°C to about 900°C for from about 20 to 60 seconds. This higher anneal temperature serves to convert the less stable C49 phase titanium silicide to the more stable C54 phase, as is well known to those skilled in this art.

In a preferred mode of practicing the claimed process of the invention, at least the first annealing step is carried out while maintaining a nitrogen vacuum or pressure level of from about 100 milliTorr to about 100 Torr, preferably from about 500 milliTorr to about 10 Torr, and most preferably from about 1 to about 10 Torr, as described and claimed in copending European Patent Application No. _____ (Attorney's file A5420-EP)- ,assigned to the assignee of this invention and entitled "PROCESS FOR FORMING TITANIUM SILICIDE ON A SEMICONDUCTOR WAFER", the content of which is incorporated by reference and copy of which is enclosed (Annex A).

This use of low nitrogen pressure provides for titanium silicide formation while still forming suffi-

* 1 milliTorr = 1.3 x 10⁶ bar

cient TiN to block migration of unreacted silicon to the surface and to passivate the TiN grain boundaries. This use of low nitrogen pressure during at least the first anneal step is made possible by the exclusion of exposure of the wafer to oxygen-bearing gases prior to the first anneal step in accordance with the practice of the invention claimed herein.

In another aspect of the best mode of practicing the claimed invention, the two annealing steps may be carried out without an intervening wet etch step by first annealing the wafer at a temperature of from about 500°C to about 695°C, preferably from about 600°C to about 675°C, for from 20 to 60 seconds, followed by a second rapid anneal step at a temperature of from about 800°C to about 900°C for an additional time period of from about 20 seconds to about 60 seconds, followed by the conventional etch step to selectively remove titanium nitride, as described and claimed in copending European Patent Application No. _____ (Attorney's file A5424-EP), assigned to the assignee of this invention and entitled "PROCESS FOR FORMING A LAYER OF TITANIUM SILICIDE ON A SEMICONDUCTOR WAFER", the content of which is incorporated by reference and copy of which is enclosed (Annex B).

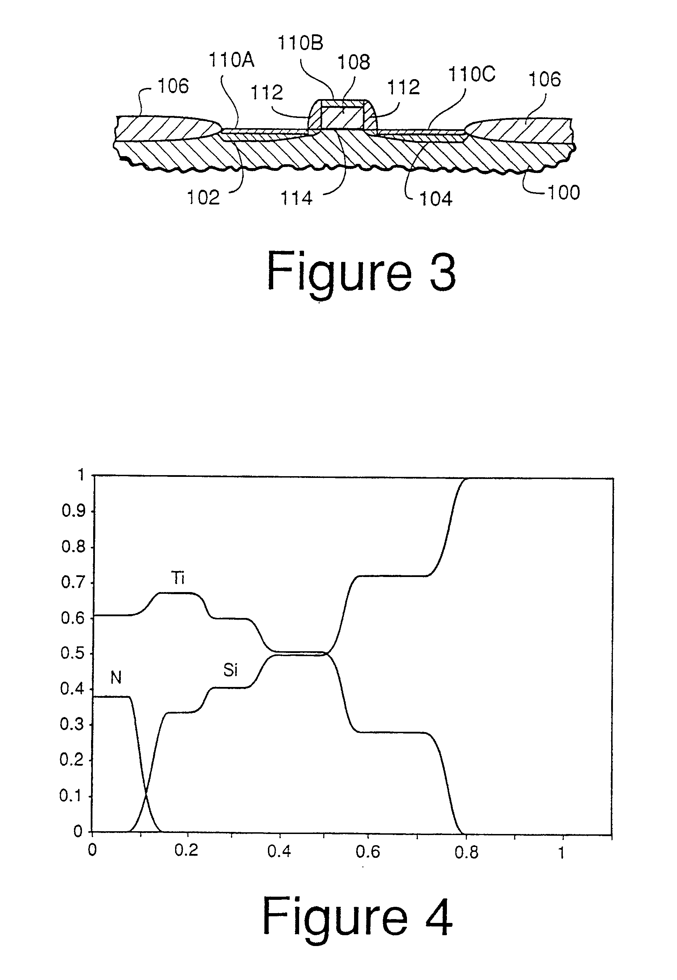

Figure 3 shows the structure formed by the process of the invention, after the first anneal step and subsequent etch. A silicon semiconductor wafer 100 is shown having silicon oxide ($SiO_2$) isolation regions 106 previously formed in the surface of the wafer and an MOS structure comprising a source region 102, a drain region 104, and a gate electrode 108 formed over gate oxide 114 with oxide spacers 112 formed on the sidewalls of gate electrode 108. Titanium silicide portions 110A, 110B, and 110C have been respectively formed by the process of the invention over the source region, the gate electrode, and the drain region as a part of the construction of the electrical contacts for the MOS device.

The Rutherford Backscattering Profile shown in Figure 4, which is taken after the first anneal, but prior to the etch step so as to show the amount of nitride present, indicates the absence of detectable oxygen in the coating, shows a higher concentration of nitrogen at the surface than in the corresponding profile of the prior art process shown in Figure 1, shows a deeper penetration of nitrogen into the layer, and most importantly, shows that no detectable amount of silicon atoms have penetrated to the surface of the layer, indicating that the titanium nitride blocking layer, formed in accordance with the invention, has successfully blocked migration of unreacted silicon atoms to the surface of the titanium/titanium silicide layer.

By use of the term "unreacted silicon atoms" is generally meant silicon which has not reacted with titanium to form the corresponding silicide - or which is not already oxidized to form silicon oxide such as the $SiO_2$ insulation regions of the semiconductor wafer under portions of the deposited titanium layer.

The following example will serve to further illustrate the process of the invention.

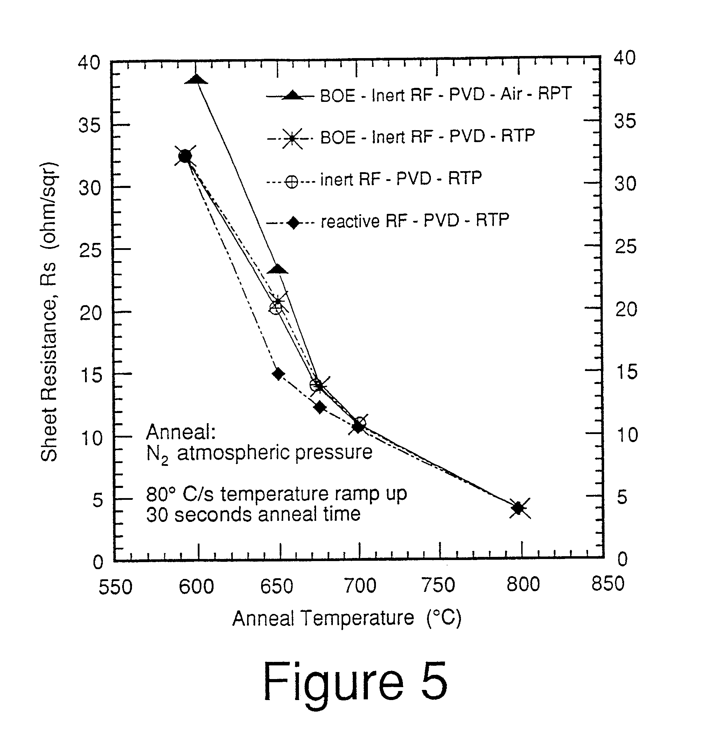

A first group of silicon wafer samples were processed in accordance with prior art procedures wherein the samples were first cleaned in an $HF/NH_4OH$ stabilizer buffered oxide wet etch (BOE), then further cleaned using an inert gas (argon) in an rf plasma, and then transferred to a titanium sputtering chamber where 500 Angstroms of titanium was sputtered onto each of the cleaned silicon wafer surfaces by a physical vacuum deposition (PVD) process. The coated wafers were then removed from the PVD chamber and transferred (through the ambient atmosphere) to a separate annealing apparatus where the coated sample wafers were then annealed, in a single annealing step, at various temperatures by a rapid thermal anneal process (RTP) in a nitrogen atmosphere for 30 seconds by ramping the respective wafer up to the anneal temperature at a rate of 80°C/sec. The sheet resistances of the resulting titanium nitride/titanium silicide layers on the samples formed at various annealing temperatures were then measured. The results are plotted in the graph of Figure 5 along the line of solid triangles.

The same procedures were then carried out on a second set of samples, except that, in accordance with one aspect of the process of the invention, the samples were not exposed to air after the titanium deposition step but were, instead, transferred directly to the anneal chamber through a vacuum chamber which interconnects the deposition chamber with the annealing chamber. The measured sheet resistances for various annealing temperatures are plotted on the starred line in the graph of Figure 5.

A third set of samples were process in the same manner as the second set, except that the wet etch precleaning step was omitted. The measured sheet resistances for various annealing temperatures are plotted along the line of crossed circles in Figure 5.

Finally, a fourth set of samples was processed similar to the third set, except that instead of the inert gas rf cleaning step, in accordance with another aspect of the invention, the wafers were cleaned in a reactive rf ion etch for 40 seconds at a pressure of 3 milliTorr, a temperature of 27°C, and a plasma power level of 150 watts, using a mixture of 10 volume % $NF_3$ and the balance argon carrier gas flowing into the cleaning chamber at 15 sccm.

The measured resistances of the samples annealed at various temperatures are plotted along the solid diamond line in Figure 5.

The four lines shown in the graph of Figure 5, each representing different first step annealing temperatures for the four sets of examples, shows the sheet resistance of the resulting titanium silicide layers for each test sample plotted as a function of the annealing temperature. Since titanium reacts with the silicon oxide ($SiO_2$) at temperatures of 700°C or higher, annealing temperatures not higher than 695°C, and preferably from about 650°C to about 675°C, should be used. It can be seen that at an annealing temperature of 675°C, the sheet resistance for the sample in the fourth group, processed in accordance with the preferred embodiment of the invention (air exclusion between deposition step and first annealing step as well as a reactive rf ion cleaning), is lower than any of the other samples. At 650°C, the test samples from the second, third, and fourth sets of samples, all comprising samples process in accordance with the invention, with no exposure to oxygen and/or oxygen-bearing gases between the deposition step and the first annealing step, have lower sheet resistance than the sample at the same first annealing temperature from the first group on the diamond line representing the prior art processing.

While it is not the intention to be limited by any particular theories of operation of the invention, it is believed that the failure of the nitrogen atoms to penetrate further into the titanium/titanium silicide layer during the first annealing step in the prior art process, as typified by the first set of samples processed above, and to react with the titanium sufficiently to form a titanium nitride layer which blocks migration of silicon atoms, is due to the presence of oxygen atoms in and on the titanium layer prior to the first annealing step. The presence of such oxygen atoms is thought to both inhibit migration or penetration of the nitrogen atoms further into the layer as well as to inhibit reaction between the titanium atoms and nitrogen atoms to form the desired blocking layer of titanium nitride. This explains why the nitrogen concentration at the surface is higher and the penetration deeper in the profile of Figure 4, representing the results of the practice of the process of the invention, than that of Figure 1, which represents the results of prior art processing.

Thus, the invention provides an improved process for forming a layer of titanium silicide on the surface of a semiconductor wafer wherein excluding oxygen and/or oxygen-bearing gases such as air from the wafer, after deposition of the titanium layer thereon, results in the formation of a titanium silicide coating having more nitrogen on the surface, and deeper penetration of the nitrogen into the titanium silicide layer, resulting in more adequate formation of a titanium nitride blocking layer during the first annealing step whereby essentially no silicon can migrate to the surface from either the underlying silicon oxide portions of the wafer or from/through the newly formed titanium silicide layer.

According to a special aspect of the invention, the improved process for forming titanium silicide on a silicon semiconductor wafer which comprises:

a) providing a silicon semiconductor wafer having one or more silicon surface regions on which said titanium silicide is to be formed;

b) cleaning said wafer in a sealed cleaning chamber using an rf plasma and a gaseous mixture which includes at least one reactive gas;

c) transferring the cleaned wafer to a vacuum deposition chamber without substantially exposing said cleaned wafer to oxygen and/or oxygen-bearing gases by transferring said wafer through a sealed central chamber which is interconnected to both said vacuum deposition chamber and said cleaning chamber;

d) forming a titanium layer over said cleaned wafer in said vacuum deposition chamber in the substantial absence of oxygen and/or oxygen-bearing gases;

e) transferring the titanium coated wafer to an annealing chamber without substantially exposing the newly formed titanium layer to oxygen and/or oxygen-bearing gases by transferring said wafer through a sealed central chamber which is interconnected to both said vacuum deposition chamber and said sealed annealing chamber; and

f) annealing the titanium-coated silicon semiconductor wafer in a nitrogen-bearing atmosphere in said annealing chamber, and in the substantial absence of oxygen and/or oxygen-bearing gases, to form said titanium silicide as well as titanium nitride on the surface which inhibits migration of underlying silicon to the surface.

Preferably in the process according to the aforementioned aspect, said cleaning step further comprises flowing into said cleaning chamber a gaseous mixture containing at least one reactive gas selected from the class consisting of $NF_3$, 1-2 carbon fluorinated hydrocarbons, and mixtures of same at a rate of from about 2 to about 500 sccm reactive gas and from about 10 to about 1000 sccm carrier gas, while maintaining said plasma at a power ranging from about 20 to about 500 watts for a period of time ranging from about 1 to about 500 seconds while maintaining said cleaning chamber within a pressure range of from about 1 to about 50 milliTorr, and at a temperature within a range of from about 27°C to about 200°C.

It is further preferred in the process of the aforementioned aspect, that said annealing is carried out in a first step for a time period ranging from about 20 seconds to about 60 seconds at an annealing temperature ranging from about 650°C up to about 675°C by raising the temperature of said wafer at a rate of from about 5 to about 150°C per second while maintaining said nitrogen-bearing atmosphere in said annealing chamber at a pressure ranging from about 100 milliTorr to about 800 Torr and while flowing one or more nitrogen-bearing gases into said chamber at a rate ranging from about 500 to about 10,000 sccm.

According to a further special aspect of the invention, the improved process for forming titanium silicide on a silicon semiconductor wafer which comprises:

a) providing a silicon semiconductor wafer having one or more silicon surface regions on which said titanium silicide is to be formed;

b) cleaning said wafer in a sealed cleaning chamber using an rf plasma and a gaseous mixture containing at least one reactive gas by flowing into said cleaning chamber a gaseous mixture containing at least one reactive gas selected from the class consisting of $NF_3$, 1-2 carbon fluorinated hydrocarbons, and mixtures of same at a rate of from about 2 to about 500 sccm reactive gas and from about 10 to about 1000 sccm carrier gas while maintaining said plasma at a power ranging from about 20 to about 500 watts for a period of time ranging from about 1 to about 500 seconds while maintaining said cleaning chamber within a pressure range of from about 1 to about 50 milliTorr, and at a temperature within a range of from about 27°C to about 200°C;

c) transferring the cleaned wafer to a vacuum deposition chamber without substantially exposing said cleaned wafer to oxygen and/or oxygen-bearing gases by transferring said wafer through a sealed central chamber which is interconnected to both said vacuum deposition chamber and said cleaning chamber;

d) forming a titanium layer over said cleaned wafer in said vacuum deposition chamber in the substantial absence of oxygen and/or oxygen-bearing gases;

e) transferring the titanium coated wafer to an annealing chamber without substantially exposing the newly formed titanium layer to oxygen and/or oxygen-bearing gases by transferring said wafer through a sealed central chamber which is interconnected to both said vacuum deposition chamber and said sealed annealing chamber; and

f) annealing the titanium-coated silicon semiconductor wafer in a nitrogen-bearing atmosphere in said annealing chamber, and in the substantial absence of oxygen and/or oxygen-bearing gases, to form said titanium silicide as well as titanium nitride on the surface which inhibits migration of underlying silicon to the surface.

## Claims

1. A process for forming a conductive layer of titanium silicide on a silicon semiconductor wafer which comprises:

   forming, by vacuum deposition, a titanium layer over the wafer and

   annealing the titanium-coated silicon semiconductor wafer in a nitrogen-bearing atmosphere, the whole process being carried out in the substantial absence of oxygen and/or oxygen-bearing gases, to form a titanium silicide layer as well as titanium nitride on the surface which inhibits migration of underlying silicon to the surface.

2. The process of claim 1, further comprising the step of cleaning the wafer to remove oxides and other materials from the silicon surface thereon prior to said titanium layer deposition step.

3. A process for forming a conductive layer of titanium silicide on a silicon semiconductor wafer, especially according to claim 1 or 2, which comprises:

   a. forming a titanium layer over the wafer in a vacuum deposition chamber in the substantial absence of oxygen and/or oxygen-bearing gases;

   b. transferring the titanim-coated wafer to a sealed annealing chamber without substantially exposing the newly formed titanium layer to oxygen and/or oxygen-bearing gases; and

   c. annealing the titanium-coated silicon semiconductor wafer in a nitrogen-bearing atmosphere in said sealed annealing chamber, and in the substantial absence of oxygen and/or oxygen-bearing gases, to form a titanium silicide layer as well as titanium nitride on the surface which inhibits migration of underlying silicon to the surface.

4. The process of any of the preceding claims, wherein said titanium layer is formed in thickness from 10 nm to 500 nm (100 Å to 5000 Å), preferably from 10 nm to 100 nm (100 Å to 1000 Å).

5. The process of any of the preceding claims, which comprises the further step of cleaning said wafer in a cleaning chamber to remove oxides and other materials from the silicon surfaces thereon prior to said titanium deposition step, and then transferring said cleaned wafer from said cleaning chamber to said vacuum deposition chamber.

6. The process of claim 5, wherein said cleaning step further comprises cleaning said wafer using a gaseous mixture which includes at least one reactive gas, preferaby selected from the class consisting of $NF_3$, 1-2 carbon flourinated hydrocarbons, and mixtures of same, while maintaining an rf plasma in said cleaning chamber.

7. The process of claim 5 or 6, in which the cleaning step comprises flowing into said cleaning chamber said gaseous mixture containing at least one reactive gas at a rate of from 2 to 500 sccm reactive gas and from 10 to 1000 sccm carrier gas, while maintaining said plasma preferably at a power ranging from 20 to 500 watts for a period of time ranging from 1 to 500 seconds.

8. A process of one of claims 5 to 7, wherein the pressure in said cleaning chamber is maintained within a range of from $1.333 \cdot 10^{-3}$ to $133 \cdot 10^{-3}$ mbar (1 to 100 milliTorr) and the temperature in the fluid cleaning chamber is maintained within a range of from 27° C to 200° C.

9. The process of one of the preceding claims, wherein said annealing is carried out in a first annealing step at a temperature ranging from 600° C up to 695° C, preferably to 675° C and/or for a time period ranging from 20 seconds to 60 seconds by raising the temperature of said wafer at a rate of from 5° C/second to 150° C/second.

10. The process of one of the preceding claims, wherein said nitrogen-bearing atmosphere in said annealing chamber is maintained, during said first annealing step, at a pressure ranging from $133 \cdot 10^{-3}$ mbar to 1064 mbar (100 milliTorr to 800 Torr) while flowing one or more nitrogen-bearing gases into said chamber at a rate ranging from 500 to 10 000 sccm.

11. The process of one of the preceding claims, wherein said wafer is selectively etched after said first annealing step to remove titanium nitride and unreacted titanium and then subsequently annealed in a second annealing step at a temperature ranging from 800° C to 900° C.

12. The process of one of the preceding claims, wherein transferring said wafer from said cleaning chamber to said vacuum deposition chamber and/or from said vacuum deposition chamber to said annealing chamber is effected through a sealed central chamber which is interconnected to both said cleaning chamber and said vacuum deposition chamber and/or said vacuum deposition chamber and said sealed annealing chamber.

13. The process of claim 12 which further comprises maintaining said sealed central chamber at a pressure ranging from $13.3^{-9}$ to $13.3^{-5}$ mbar ($10^{-9}$ to $10^{-5}$ Torr).

Figure 1 (PRIOR ART)

Figure 2

# Figure 3

# Figure 4

Figure 5

CLEANING A SILICON SEMICONDUCTOR
WAFER IN A CLEANING CHAMBER USING
ONE OR MORE REACTIVE GASES
WITH AN RF PLASMA

MOVING THE CLEANED WAFER TO A
VACUUM DEPOSITION CHAMBER WITHOUT
EXPOSING THE CLEANED WAFER
TO OXYGEN-BEARING GASES

DEPOSITING A LAYER OF TITANIUM ON
THE CLEANED SEMICONDUCTOR WAFER

MOVING THE WAFER FROM THE VACUUM
DEPOSITION CHAMBER TO AN ANNEALING
CHAMBER WITHOUT EXPOSING THE COATED
WAFER TO OXYGEN-BEARING GASES

ANNEALING THE COATED WAFER IN
A NITROGEN-BEARING ATMOSPHERE
TO FORM TITANIUM SILICIDE
AND TITANIUM NITRIDE

# Figure 6